# EUROPÄISCHE PATENTSCHRIFT

(11) **EP 0 801 521 B1**
(45) Veröffentlichungstag und Bekanntmachung des Hinweises auf die Patenterteilung: **17.03.1999**
(21) Anmeldenummer: 97105506.6
(22) Anmeldetag: 03.04.1997
(51) Int. Cl.: H05K 9/00, H01R 43/20

(54) **Verfahren zur Herstellung von elektrisch leitenden Durchführungen in metallisierten Kunststoffgehäusen**
Process for the manufacturing of electrically conductive passages in metallised plastic casings
Procédé de fabrication de traversées électriquement conductrices dans des boîtiers en plastique metallisé

(30) Priorität: 13.04.1996 DE 19614706
(43) Veröffentlichungstag der Anmeldung: 15.10.1997
(73) Patentinhaber: TEMIC TELEFUNKEN microelectronic GmbH, 74072 Heilbronn (DE)
(72) Erfinder: Knödler, Dieter, 73107 Eschenbach (DE)
(74) Vertreter: Maute, Hans-Jürgen, Dipl.-Ing.

(56) Entgegenhaltungen:
- EP-A- 0 657 960
- DE-A- 3 313 970
- US-A- 5 046 243
- HIDEKI YUMOTO: "FEEDTHRU ASSEMBLY TECHNIQUE WITH REDUCED SOLDER WICK" 1.April 1991 , MOTOROLA TECHNICAL DEVELOPMENTS, VOL. 12, PAGE(S) 77 XP000229272

## Beschreibung

Die Erfindung bezieht sich auf ein Verfahren zur Herstellung von elektrisch leitenden Durchführungen in metallisierten Kunststoffgehäusen für Elektro-nikanwendungen, vgl. z. B. EP-A-0657960 und Motorola Technical Developments, Vol 12, Page 77, April 1991 ; Hideki Yumoto: "Feedthru Assembly Technique with reduced solder wick".

Metallisierte Kunststoffgehäuse kommen als kostengünstige Alternative gegenüber herkömmlichen Metallgehäusen für den Einsatz bei Elektronik- und Mikroelektronikanwendungen in Frage. Die Herstellung von elektrisch leitenden Durchführungen bei metallisierten Kunststoffgehäusen wird zum jetzigen Stand der Technik durch verschiedene Verfahren realisiert. Eine Möglichkeit besteht in einem Einpressen von einfachen Metallstiften oder Nagelkopfstiften bzw. werden die Stifte bereits mit eingespritzt. Eine zweite Möglichkeit besteht im Einlöten oder Einkleben der Stifte in bereits metallisierte Gehäuseteile. Bei beiden Verfahren ist jedoch eine Isolierung der Stifte gegenüber der Gehäusemetallisierung zur Vermeidung von elektrischen Kurzschlüssen notwendig. Dies erfolgt durch aufwendige Arbeitsgänge, wie z. B. einer Maskierung beim Herstellen der Metallisierung oder durch nachträgliches Durchtrennen der Metallisierungsschicht um die Durchführungsbohrungen herum oder durch sequentielles Bohren oder Fräsen. Bei eingepreßten oder eingespritzten Stiften ist die Erzielung einer, für viele Anwendungen geforderten, hohen Gasdichtheit problematisch. Ein weiteres Verfahren sieht, entsprechend wie bei Metallgehäusen, das Einlöten oder Einkleben von relativ teuren, glasisolierten Metallstiften vor. Dadurch wird eine bessere Gasdichtigkeit erzielt.

Der vorliegenden Erfindung liegt die Aufgabe zugrunde, ein Verfahren zur Herstellung von elektrischen Durchführungen in metallisierten Kunststoffgehäusen anzugeben, bei dem die Isolation von Durchführungsstiften gegenüber der Gehäusemetallisierung vereinfacht und kostengünstig zu realisieren ist. Gleichzeitig soll eine hohe Gasdichtheit und EMV-Abschirmung erzielt werden.

Diese Aufgabe wird durch ein Verfahren mit den Merkmalen des Anspruchs 1 gelöst.

Die vorteilhafte Ausgestaltung erfolgt gemäß den Merkmalen der abhängigen Ansprüche.

Kurze Beschreibung der Figuren:
- Figur 1a: zeigt einen Querschnitt durch ein Gehäuseteil zu einem ersten Zeitpunkt des Herstellungsverfahrens.
- Figur 1b: zeigt einen Querschnitt durch ein Gehäuseteil zu einem zweiten Zeitpunkt des Herstellungsverfahrens.
- Figur 1c: zeigt einen Querschnitt durch ein Gehäuseteil zu einem dritten Zeitpunkt des Herstellungsverfahrens.
- Figur 1d: zeigt einen Querschnitt durch ein Gehäuseteil zu einem vierten Zeitpunkt des Herstellungsverfahrens.
- Figur 2: zeigt einen Querschnitt durch ein Gehäuseteil mit eingefügtem Metallstift mit einer zweiten Ausgestaltung der Erhöhungen.
- Figur 3: zeigt einen Querschnitt durch ein Gehäuseteil mit eingefügtem Metallstift mit einer dritten Ausgestaltung der Erhöhungen.
- Figur 4: zeigt einen Querschnitt durch ein Gehäuseteil mit eingefügtem Metallstift mit einer vierten Ausgestaltung der Erhöhungen.
- Figur 5: zeigt einen Querschnitt durch ein Gehäuseteil mit eingefügtem Metallstift mit einer fünften Ausgestaltung der Erhöhungen.

Nachfolgend wird die Erfindung anhand eines Ausführungsbeispiels unter Zuhilfenahme der Figuren erläutert.

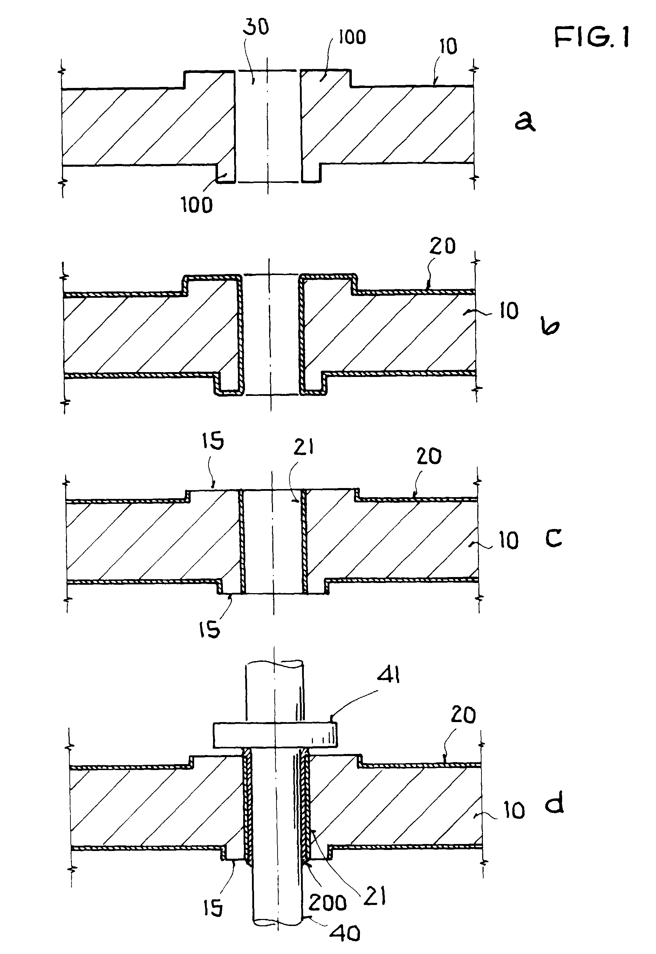

Durch ein entsprechend gestaltetes Werkzeug werden beim Spritzguß des Gehäusebodens 10 die Bohrungen 30 für die Kontaktstifte 40 sowie vornehmlich kreisförmige bzw. kreisringförmige Erhöhungen 100, 101 der Bodenfläche um die Durchführungsbohrungen 30 im gleichen Arbeitsgang mit hergestellt. Ein Querschnitt des Gehäuseteils nach diesem Verfahrensschritt ist in Figur 1a dargestellt.

Danach wird das Teil ganzflächig, d. h. ohne Maskierung, metallisiert 20. Auch die Innenseiten der Durchführungsbohrungen 30 werden metallisiert (Figur 1b). Zur notwendigen Isolation 15 der später einzubringenden Durchführungsstifte 40 wird nun die Metallisierungsschicht um die Bohrungen entfernt (Figur 1c). Durch die Erhöhungen 100, 101 des Gehäusebodens um die Bohrungen 30 ist dieser Arbeitsschritt ohne aufwendige Justierung oder Maskierung kostengünstig und auch für große Serien z. B. durch einfaches Abschleifen der Metallisierung auf den Erhöhungen 100, 101 auszuführen, ohne daß die Metallisierung 20 auf den tieferliegenden Flächen beschädigt wird. Eine Voraussetzung für dieses Verfahren ist, daß der Rand des Gehäusebodens unterhalb des Niveaus der Erhöhungen für die Isolation bleibt, wenn hier die Metallisierung für den späteren Gehäuseverschluß, z. B. durch Löten, erhalten bleiben soll. Die Durchführung kann nun durch das Einlöten bzw. Einkleben eines Stiftes 40 aus Metall, vorzugsweise mit angeformtem Ring 41 oder Wulst 42, fertiggestellt werden (Figur 1d). Durch das Lot bzw. den Kleber 200 wird eine hermetische Abdichtung zwischen Durchführungsmetallisierung 21 und Stift 40 erreicht. Ein Einpressen des Stiftes ist dabei nicht erforderlich. Ein am Stifte angeformter Ring 41 oder Wulst 42 ermöglicht eine einfache und genaue Höhenpositionierung des Stiftes sowie eine gute EMV-Abschirmung.

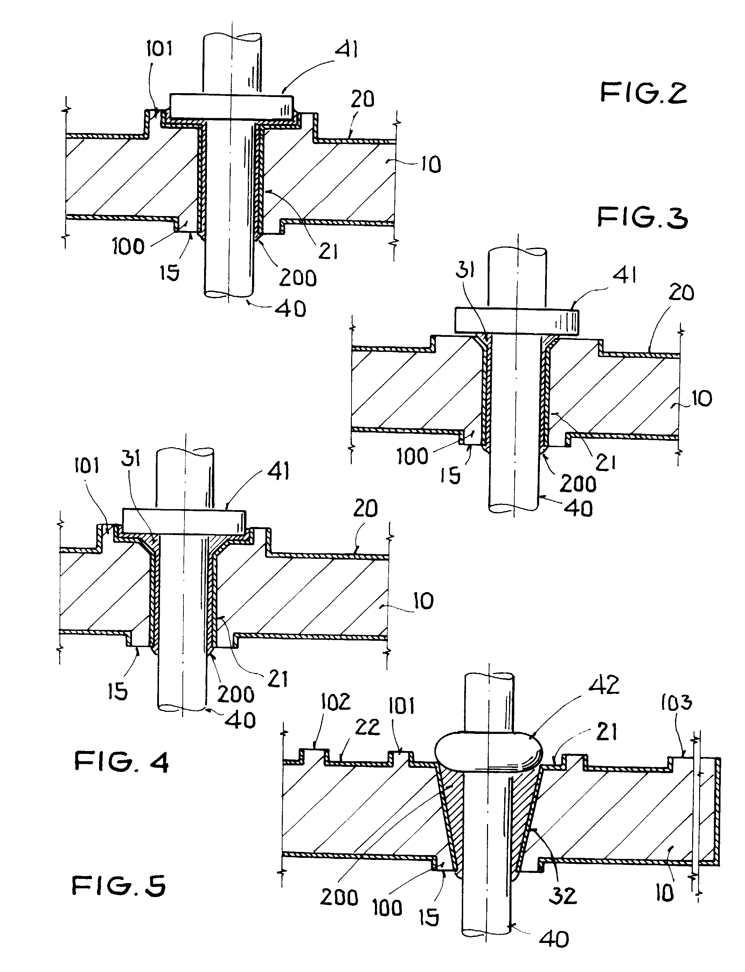

Als Varianten sind noch eine besondere ringförmige Ausführung der Erhöhung 101 für die Isolation zur besseren EMV-Abschirmung bzw. zum großflächigeren Anlöten des Kontaktstiftes (Fig. 2), Erweiterungen 31 an den Bohrungsenden als Lot-/Kleberreservoir (Fig. 3) sowie eine Kombination dieser Varianten (Fig. 4) möglich. Die Herstellung der Isolation 15 durch Entfernen der Metallisierung kann in diesen Fällen auf die gleiche Art, z. B. durch Schleifen, erfolgen. Die Durchführungsbohrung kann weiterhin eine konische Form besitzen. In Verbindung mit dem Stiftwulst führt dies zu einer Selbstzentrierung des Stiftes (Figur 5).

Im Falle eines späteren Gehäuseverschlusses durch Kunststoffverschweißung kann jedoch auch die Entfernung der Metallisierung am Rand des Gehäuseteiles erwünscht sein. Hierzu muß dann der Rand des Gehäuseteiles auf gleichem Niveau wie die anderen zu isolierenden Flächen liegen (Figur 5).

Auf die oben beschriebene Art und Weise der Isolierung von einzelnen Metallisierungsflächen gegeneinander, lassen sich auch für bestimmte Anwendungsfälle Leiterbahnstrukturen 22 erzeugen, wobei diese Leiterbahnen 22 durch Erhöhungen 102 des Gehäusekunststoffes 10 begrenzt werden (Figur 5).

## Patentansprüche

1. Verfahren zur Herstellung von elektrisch leitenden Durchführungen für metallisierte Kunststoffgehäuse, wobei Metallstifte (40) in Durchführungsbohrungen (30) mindestens eines Gehäuseteils (10) eingelötet oder eingeklebt werden, gekennzeichnet durch folgende Verfahrensschritte:
a) Ausformung von Erhöhungen (100, 101) um die Durchführungsbohrungen (30) im Gehäuseteil (10) herum,
b) ganzflächige Metallisierung (20) des Gehäuseteils (10),
c) Abtragung der Metallisierung auf den Erhöhungen (100, 101) um die Durchführungsbohrungen (30) herum durch flächig wirkende, mechanische Verfahren, wobei durch den Niveauunterschied die tieferliegenden Metallisierungsflächen (20) unbearbeitet bleiben und
d) Einlöten oder Einkleben der Metallstifte (40) in die Durchführungsbohrungen (30).

2. Verfahren nach Anspruch 1, dadurch gekennzeichnet, daß die Ausformung der Erhöhungen (100, 101) beim Herstellen der Gehäuseteile erfolgt.

3. Verfahren nach Anspruch 1 oder 2, dadurch gekennzeichnet, daß die Erhöhungen (100, 101) um die Bohrungen (30) herum kreisförmig, kreisringförmig oder vieleckig geformt sind.

4. Verfahren nach einem der Ansprüche 1 bis 3, dadurch gekennzeichnet, daß das Gehäuseteil (10) einen erhöhten Rand (103) aufweist und daß der Rand (103) des Gehäuseteils (10) das gleiche Niveau wie die Erhöhungen (100, 101) um die Durchführungsbohrungen (30) herum aufweist und so dort die Metallisierung im gleichen Arbeitsgang mit den Erhöhungen (100, 101) entfernt werden kann.

5. Verfahren nach einem der Ansprüche 1 bis 4, dadurch gekennzeichnet, daß im Gehäuseteil (10) weitere, bestimmte Flächen umschließende Erhöhungen (102) eingeformt sind, wodurch im gleichen Verfahrensschritt durch die Abtragung der Metallisierung der Erhöhungen (102) auf dem tieferliegenden Niveau gegenüber der Restmetallisierung isolierte Leiterbahnstrukturen (22) gebildet werden.

6. Verfahren nach einem der Ansprüche 1 bis 5, dadurch gekennzeichnet, daß die Durchführungsbohrungen (30) an mindestens einem Ende eine Erweiterung (31) aufweisen.

7. Verfahren nach einem der Ansprüche 1 bis 6, dadurch gekennzeichnet, daß die Durchführungsbohrungen (32) konisch ausgebildet sind.

## Claims

1. Process for producing electrically conductive feed-throughs for metallised plastics casings, wherein metal pins (40) are soldered or glued into feed-through holes (30) of at least one casing part (10), characterised by the following process steps:
a) the formation of elevations (100, 101) around the feedthrough holes (30) in the casing part (10),
b) all-over metallisation (20) of the casing part (10),
c) removal of the metallisation on the elevations (100, 101) around the feed-through holes (30) by planar, mechanical processes, with the metallisation surfaces (20) at a lower level remaining untreated due to the difference in level and
d) soldering or gluing the metal pins (40) into the feed-through holes (30).

2. Process according to claim 1, characterised in that the elevations (100, 101) are formed when the casing parts are produced.

3. Process according to claim 1 or 2, characterised in that the elevations (100, 101) around the holes (30) are formed in circular, circular ring-shaped or polygonal fashion.

4. Process according to any one of claims 1 to 3, characterised in that the casing part (10) has a raised edge (103), and that the edge (103) of the casing part (10) is at the same level as the elevations (100, 101) arround the feed-through holes (30) and the metallisation can thus be removed here in the same operation which removes that on the elevations (100, 101).

5. Process according to any one of claims 1 to 4, characterised in that further elevations (102), which enclose certain areas, are formed in the casing part (10), so that by removing the metallisation of the elevations (102) insulated conductor track structures (22) are formed in the same process step at a lower level with respect to the remaining metallisation.

6. Process according to any one of claims 1 to 5, characterised in that the feed-through holes (30) have an enlargement (31) at least at one end.

7. Process according to any one of claims 1 to 6, characterised in that the feed-through holes (32) are conical.

## Revendications

1. Procédé de fabrication de traversées électriquement conductrices pour boîtiers de plastique métallisés, dans lequel des broches métalliques (40) sont insérées puis brasées ou collées dans des perçages de traversée d'au moins une partie de boîtier (10), caractérisé par des pas de procédé suivants :
a) formage, vers l'extérieur d'éminences (100, 101) autour des perçages de traversée (30) dans la partie de boîtier (10),
b) métallisation (20) de toute la surface de la partie de boîtier (10),
c) élimination de la métallisation sur les éminences (100, 101) autour des perçages de traversée (30) par un procédé mécanique agissant à plat, dans lequel, du fait de la différence de niveau, les surfaces de métallisation (20) plus profondes ne sont pas atteintes et
d) insertion du brasage ou collage des broches métalliques (40) dans les perçages de traversée (30).

2. Procédé selon la revendication 1, caractérisé par le fait que le format, vers l'extérieur, des éminences (100, 101) se fait lors de la fabrication des parties de boîtier.

3. Procédé selon la revendication 1 ou 2, caractérisé par le fait que les éminences (100, 101) autour des perçages (30) sont de forme circulaire, en forme d'anneau circulaire ou de forme polygonale.

4. Procédé selon l'une des revendications 1 à 3, caractérisé par le fait que la partie de boîtier (10) présente un bord surélevé (103) et que le bord (103) de la partie de boîtier (10) présente le même niveau que les éminences (100, 101) qui sont autour des perçages de traversée (30) et qu'ainsi la métallisation peut y être éliminée au cours du même pas de travail qu'autour des éminences (100, 101).

5. Procédé selon l'une des revendications 1 à 4, caractérisé par le fait que dans la partie de boîtier (10) sont formées des éminences (102) entourant d'autres surfaces déterminées, ce par quoi dans le même pas de travail, par l'élimination de la métallisation des éminences (102) sont formées, sur le niveau plus profond, des structures de rubans conducteurs (22) isolés par rapport au reste de la métallisation.

6. Procédé selon l'une des revendications 1 à 5, caractérisé par le fait que les perçages de traversée (30) présentent, à au moins une extrémité, un élargissement (31).

7. Procédé selon l'une des revendications 1 à 6, caractérisé par le fait que les perçages de traversée (32) sont de forme conique.
